Europäisches Patentamt

European Patent Office

Office européen des brevets

(19)

(11) Numéro de publication: **0 026 929**
**A1**

## (12) DEMANDE DE BREVET EUROPEEN

(21) Numéro de dépôt: **80106008.8**

(51) Int. Cl.³: **H 03 G 3/32**

(22) Date de dépôt: **03.10.80**

(30) Priorité: **03.10.79 FR 7924629**

(71) Demandeur: **Carpentier, Claude, 163, rue Armand Silvestre, F-92400 Courbevoie (FR)**

(43) Date de publication de la demande: **15.04.81 Bulletin 81/15**

(72) Inventeur: **Carpentier, Claude, 163, rue Armand Silvestre, F-92400 Courbevole (FR)**
Inventeur: **Kiennert, Claude, rue Jean Longue, F-92290 Châtenay-Malabry (FR)**

(84) Etats contractants désignés: **AT BE CH DE GB IT LI LU NL SE**

(74) Mandataire: **BUREAU D.A. CASALONGA, Lilienstrasse 77, D-8000 München 80 (DE)**

(54) **Dispositif permettant l'ajustement automatique du niveau des sources sonores utiles dans les milieux à bruyance variable.**

(57) Un amplificateur linéaire à gain commandé (AGC) est piloté par une tension n.VB proportionnelle à la pression acoustique partielle de bruit. Cette tension est obtenue par calcul analogique en temps réel de la fonction:

$$n.VB = n. (VM^2 - VS^2) 1/2$$

dans laquelle VM est une tension proportionnelle à la pression acoustique totale recueillie par un micro (M) et VS une tension de signal recueillie aux bornes du haut-parleur (HI).

Le dispositif permet de conserver le rapport des intensités sonores signal/bruit dans des limites préalablement établies.

L'invention est destinée à l'équipement des voitures automobiles et des installations sonores situées au voisinage d'aéroports, de lignes S.N.C.F., de voies à grande circulation.....

Dispositif permettant l'ajustage automatique du niveau des sources sonores utiles dans les milieux à bruyance variable.

La présente invention a pour objet un dispositif améliorant les conditions d'écoute des sources sonores utiles dans les milieux bruyants, et dont le niveau de bruit varie fréquemment et sensiblement.

Dans ces milieux, le confort d'écoute nécessite un ajustage fréquent de la puissance de la source sonore utile.

Le dispositif suivant l'invention réalise l'ajustage automatique du niveau sonore de la source utile en fonction du niveau de bruit, de manière à conserver intacte la lisibilité du message sonore.

Les véhicules automobiles sont l'exemple type de ces milieux à bruyance variable et constituent pour la présente invention le débouché potentiel le plus important. Ainsi, nous raisonnerons pour décrire l'invention sur le schéma synoptique d'une réalisation destinée à l'automobile. Il paraîtra évident au lecteur averti que son principe est tout à fait général et peut améliorer les dispositifs de sonorisation des salles de spectacles, réfectoires, ateliers... et aussi les installations radio et T.V. de particuliers situés à proximité d'aéroports, de lignes S.N.C.F., de grandes nationales, etc...

Nombre d'inventeurs se sont penchés sur ce problème, et les solutions proposées empruntent deux voies distinctes :

La première consiste à faire l'inventaire des causes du bruit, de les saisir par des capteurs et de traiter les informations reçues pour commander le gain de la source sonore utile. Par exemple, la marque REELA commercialise un appareil (AV 6000) qui asservit la puissance d'un autoradio à la vitesse de rotation d'un moteur automobile. Il est évident que ce seul dispositif ne permet pas de résoudre tous les problèmes de bruit d'une voiture. Il faudrait lui adjoindre un capteur de vitesse de la voiture, de la vitesse et de la direction du vent, de la position des glaces latérales et de l'état de la chaussée. Cet exemple illustre bien les limites de cette voie qui ne permet de traiter que les cas simples.

La seconde voie est plus générale. Elle consiste à réaliser un dispositif sonométrique capable de mesurer le bruit ambiant dans lequel baigne la source utile et à asservir le gain de l'amplificateur de la source utile au résultat de la mesure sonométrique. Le lecteur averti connaît l'obstacle qu'il faut franchir pour que le système fonctionne correctement. En effet, pour que le message sonore soit lisible, son niveau doit être au moins de l'ordre de celui du bruit ambiant. Ainsi, si l'on asservit sans précaution le gain de l'amplificateur de la source utile au résultat de la mesure sonométrique, le système, incapable de distinguer le signal du bruit, confond le premier fortissimo venu avec un bruit intempestif, et, ainsi, s'enclenche un processus de réaction positive qui maintient le système autour de son gain maximum, ce qui n'est évidemment pas le but recherché.

Pour que le système fonctionne correctement, il faut donc le rendre apte à distinguer le signal du bruit. Pour y parvenir, trois moyens ont fait l'objet de demandes de brevet.

Le premier supprime le signal pendant des temps très courts, inférieurs à la constante de temps de l'oreille humaine (1/15ème de seconde) et effectue la mesure du bruit pendant ces temps.

Le second préconise de travailler sur certaines fréquences pour le bruit et sur d'autres pour le signal.

Selon le troisième, la mesure du bruit ne s'effectue qu'aux moments où le signal descend en-dessous d'un certain niveau négligeable devant celui du bruit. Le résultat est gardé en mémoire jusqu'au moment où la mesure suivante devient possible.

Aucune de ces trois solutions n'est satisfaisante et ceci pour les raisons suivantes :

La première suppose en effet d'opérer dans un local sans réverbération car, dans un local courant, une voiture par exemple, l'intensité sonore y régnant 1/20ème de seconde après la coupure d'un signal n'est que de 4 dB inférieure à son niveau au moment de la coupure.

La seconde impose soit de mutiler largement le message sonore, soit de travailler sur des bandes de fréquence de bruit situées en dehors du spectre audible en spéculant sur la composition spectrale du bruit.

La troisième est inapplicable en automobile car les mesures ne seraient pas assez fréquentes eu égard aux vitesses courantes de montée de bruit qui sont de l'ordre de 2 dB/seconde.

0026929

Ces remarques expliquent en partie qu'aucun dispositif basé sur la mesure sonométrique ne soit - à notre connaissance - exploité commercialement.

Les trois méthodes sonométriques ci-dessus exposées ont un point commun : elles tentent de séparer physiquement le signal du bruit.

Le dispositif suivant l'invention emprunte la voie sonométrique mais se distingue des solutions précédentes en ce que la pression acoustique partielle de bruit n'est pas obtenue par séparation physique du signal et du bruit, mais par calcul analogique en temps réel d'une fonction de la pression acoustique totale et de la pression acoustique de signal.

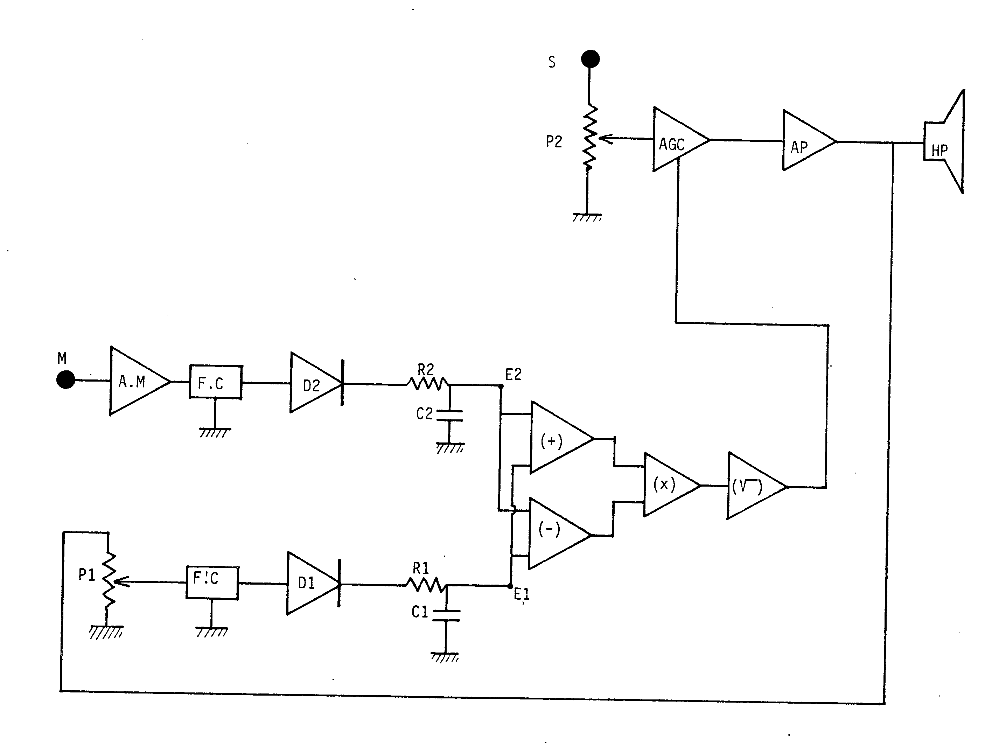

La figure indique le schéma synoptique d'une réalisation suivant l'invention destinée à l'automobile.

Le signal d'entrée "S" provenant de la sortie haut-parleur de l'autoradio est appliqué par l'intermédiaire d'un potentiomètre P2, destiné à ajuster les niveaux, à un amplificateur linéaire à gain commandé "A.G.C." lequel pilote un amplificateur de puissance "A.P." délivrant la puissance requise.

Dans la réalisation suivant l'invention, l'excursion en tension du gain de l'A.G.C. est de 26 dB et sa tension de commande est calculée pour que son "décollage" se produise à un niveau de bruit de 64 dB. La limite supérieure d'intervention se situe à un niveau de bruit de 90 dB. Entre ces deux valeurs, la tension de commande ajuste le gain de l'A.G.C. de manière à conserver la valeur du rapport signal/bruit existant au niveau de bruit de 64 dB.

Le potentiomètre P2 est réglé de manière à ce que les gains en tension et en puissance de l'ensemble soient de 1 quand le niveau de bruit est inférieur ou égal à 64 dB. Au niveau 90 dB le gain de l'ensemble est de 20 en tension, donc 400 en puissance. Le système permet donc de passer automatiquement d'une puissance de 50 mWatt à une puissance de 20 Watts.

Examinons maintenant comment est obtenue la tension de commande.

Le circuit A.G.C. étant calculé pour que son gain en tension soit proportionnel à la tension de commande, notre système fonctionnera correctement si on lui applique une tension de commande proportionnelle à la pression acoustique partielle de bruit régnant dans le local. Ainsi, la puissance électrique aux bornes du haut-parleur - donc l'intensité sonore du signal mesurée en phones - varie en raison quadratique de cette tension et compense la variation de l'intensité sonore du bruit. Nous savons en effet que l'intensité sonore est une fonction quadratique de la pression acoustique de bruit. Le rapport des intensités sonores de signal et de bruit sera donc conservé.

Aux bornes d'un micro "M" placé à proximité de l'auditeur, nous recueillons en fonctionnement normal une tension VM composée en fonctionnement normal de signal et de bruit. Cette tension est proportionnelle à la pression acoustique totale PT régnant dans le local. Dans la mesure où les pressions acoustiques partielles de signal et de bruit ne sont pas corrélées, nous avons la relation :

$$PT^2 = PS^2 + PB^2$$

où PS et PB désignent respectivement les pressions acoustiques partielles de signal et de bruit. Et nous avons de manière analogue :

$$VM^2 = VSM^2 + VBM^2$$

où VSM et VBM représentent les tensions partielles de signal et de bruit recueillies par le micro. Cette tension VM est amplifiée à travers "A.M." puis traverse un filtre correcteur sur l'utilité duquel nous reviendrons. Puis elle est redressée dans D2 (sans seuil) et intégrée en R2C2 avec une constante de temps de 6 secondes (non critique). Nous obtenons donc en E2 une tension continue

$$VE^2 = n_2 (VSM^2 + VBM^2)^{1/2} \text{ où } n_2 \text{ est une constante.}$$

D'autre part, nous prélevons une tension de signal après l'A.G.C. par exemple aux bornes du haut-parleur. Cette tension est amenée à travers P1 filtrée suivant F'C couplé à FC redressée en D1 et intégrée en R1C1 avec la même constante de temps de 6 secondes.

Nous obtenons donc en E1 une tension continue proportion-

nelle au signal.

$$VE1 = n_1 VSA$$

En l'absence de bruit, avec des transducteurs et une acoustique parfaits, VSM et VSA sont rigoureusement proportionnelles et nous pouvons obtenir par ajustage de P1 une égalisation parfaite des tensions en E1 et E2 :

$$VE1 = VE2 = nVS$$

Si maintenant, nous ajoutons du bruit, nous obtenons :

En E1 : $VE1 = n.VS$         (1)

En E2 : $VE2 = n.(VS^2 + VB^2)1/2$   (2)

Nous avons vu que pour commander l'A.G.C. il nous fallait obtenir une tension proportionnelle à la tension de bruit VB.

Des relations (1) et (2) il est mathématiquement aisé de tirer :

$$n.VB = (VE2^2 - VE1^2)1/2 \qquad (3)$$

Par un choix judicieux de n, n.VB peut être parfaitement apte à piloter notre A.G.C.

Il ne nous reste donc plus qu'à réaliser un petit calculateur analogique capable de calculer la différence quadratique entre deux tensions.

Actuellement, la méthode la moins coûteuse consiste à faire la somme de VE1 et VE2 dans un circuit sommateur, puis leur différence dans un circuit de différence, de multiplier les deux tensions obtenues dans un circuit multiplicateur et d'extraire la racine carrée de la tension obtenue dans un circuit aménagé à cet effet (circuit multiplicateur convenablement bouclé). Il est évident que la méthode de calcul pourra varier en fonction de l'évolution de la technologie des composants électroniques. Dans un avenir proche, il sera d'ailleurs possible d'effectuer ce calcul avec un seul circuit intégré et un minimum de composants périfériques.

Cette tension de bruit n.VB que nous obtenons par calcul, est notamment celle que nous pouvons obtenir en l'absence de signal. Le fonctionnement rigoureux de notre dispositif est donc aisément vérifiable à chaque instant en coupant le signal.

Maintenant, que se passe-t-il dans la pratique lorsque nous utilisons des éléments imparfaits, c'est-à-dire des transducteurs non linéaires en fréquence et un local acoustique réverbérant ? Le lecteur averti sait que dans ces conditions, des essais en fréquences fixes font apparaître des différences de rendement de l'ordre de 25 dB de la chaîne transductrice. Ainsi le rapport VSM/VSA varie avec la fréquence, ce qui entraîne des erreurs sur le calcul de VB et donc des excursions intempestives de la tension de commande de gain. Heureusement, dans la pratique, un certain nombre de facteurs vont jouer en notre faveur et simplifier la tâche du filtre (FC, F'C) dont le rôle est de linéariser en fréquence la courbe de réponse de la chaîne transductrice. Ces facteurs favorables sont les suivants :

1°) Afin de compenser la variation de sensibilité de l'oreille avec les fréquences, nous devrions en toute rigueur adopter en FC et F'C des filtres dont la courbe de réponse serait celle adoptée dans les mesures de bruits et normalisée "A". Cette courbe en cloche avec fréquences de coupure à 500 Hz et 10.000 Hz présente notamment des affaiblissements de 20 dB à 100 Hz et 10 dB à 20.000 Hz.

Dans la pratique, nous avons pu couper à 12 dB par octave à 500 Hz et 4.000 Hz et ne garder que les fréquences de bruit situées entre ces deux limites sans conséquences néfastes quant à l'évaluation du bruit.

Le lecteur averti aura compris que cette opération nous a fait parcourir plus des trois-quarts du chemin.

2°) Un local se comporte beaucoup mieux pour les messages sonores courants que pour les fréquences fixes car les fréquences privilégiées n'ont pas le temps de s'établir en ondes stationnaires. La focalisation de l'intensité sonore sur des ventres de pression acoustique disparaît, et le micro ne se trouve plus alternativement dans un ventre ou dans un noeud de pression comme c'est le cas quand nous travaillons sur fréquence glissante.

3°) La constante de temps de 6 secondes a été choisie comme celle qui convenait le mieux à l'automobile. Elle permet de suivre sans problème les montées et descentes de niveau afférentes aux accélérations et ralentissements de la voiture et amortit considérablement l'influence des bruits importants mais éphémères dont la prise en compte se révèlerait être plus un inconvénient qu'un avantage pour le confort d'écoute.

De la même manière, cette constante de temps va réduire considérablement les erreurs instantanées de calcul de la tension de bruit et, ainsi, le dispositif peut supporter des erreurs de calcul de plus de 10 dB pendant près de 2 secondes, ce qui pratiquement n'arrive jamais.

Ainsi, avec un seul filtre passe-bande 500-4.000 Hz, il n'a pu être décelé à l'oreille d'excursion gênante sur plusieurs heures d'écoute avec le même dispositif adapté sur des véhicules et des haut-parleurs différents.

Il n'en reste pas moins vrai que les résultats n'en seront que meilleurs avec un filtre adapté au véhicule et aux transducteurs.

La description du dispositif a été faite en monophonie. Dans un dispositif polyphonique, le micro sera placé au barycentre des sources utiles et il sera prélevé sur chaque amplificateur une tension de signal. Il en sera fait la moyenne qui sera appliquée en P1. Il y aura autant d'A.G.C. que de canaux mais un seul calculateur.

Dans une variante, la tension de signal pourra être recueillie aux bornes de la bobine réceptrice d'un haut-parleur à deux bobines du type utilisé dans les enceintes asservies. En effet, cette tension est plus proche de celle du micro que la tension alimentant la bobine motrice, donc, l'erreur commise dans le calcul de VB s'en trouve diminuée. Mais cette formule, outre qu'elle nécessite un haut-parleur plus coûteux, supprime un avantage du dispositif que nous avons passé sous silence : lorsque les haut-parleurs travaillent à leur limite de saturation, leur rendement décroît, la tension VSM croît moins vite que VSA. Le système se déséquilibre, pert du gain, la dynamique est comprimée et l'écoute plus agréable.

La présente invention pourra trouver trois formes d'application principales.

La première est un amplificateur de puissance automatique s'adaptant sans modification des installations existantes. Dans ce cas, dans le double souci de préserver la garantie des ap-

0026929

pareils et de faciliter le montage, le dispositif s'intercalera entre les sorties haut-parleur de l'installation et les haut-parleurs eux-mêmes.

La seconde est un circuit venant s'intercaler au niveau du potentiomètre de puissance des appareils existants. Il peut être intérieur ou extérieur à l'appareil et utilise son amplificateur de puissance. Dans les deux cas, son adaptation doit être prévue par le fabricant de l'appareil.

La troisième est un pré-équipement du local. Dans ce cas, le local, une automobile par exemple, est pré-équipé d'un dispositif comportant un amplificateur à commande automatique de gain et un système de haut-parleurs, installation que les clients peuvent compléter avec des tuners et autres lecteurs de leur choix. Cette solution permet de mettre le micro dans une position acoustiquement idéale, ce qui n'est pas toujours possible en post-équipement.

# REVENDICATIONS

0026929

1. Dispositif d'ajustage automatique du niveau d'une source sonore utile en fonction du bruit ambiant, du type comportant un amplificateur à gain commandé (AGC) possédant une entrée de signal (S, P2) et également une entrée de commande et une sortie alimentant un haut parleur (HP) par l'intermédiaire d'un amplificateur de puissance (AP), ladite entrée de commande étant connectée à la sortie d'un circuit compensateur à deux entrées (E1 et E2) dont l'une (E1) est réunie à la sortie d'un premier circuit comportant un potentiomètre d'équilibrage (P1) recevant le signal sortant en aval de l'amplificateur à gain commandé et transmettant ce signal à un redresseur (D1) puis un circuit intégrateur (R1C1) dont la sortie est connectée à cette entrée (E1), et l'autre (E2) est connectée à un deuxième circuit comportant un micro d'ambiance (M) alimentant par un amplificateur (AM) un deuxième redresseur (D2) et un deuxième circuit intégrateur (R2C2) dont la sortie est reliée à cette entrée (E2), dispositif caractérisé par le fait que ledit circuit de compensation est agencé de manière à fournir à sa sortie une tension quasi continue de commande de l'amplificateur à gain commandé (AGC) qui soit proportionnelle à la racine carrée de la différence entre les carrés des tensions quasi continues fournies respectivement à ladite deuxième entrée (E2) et à ladite première entrée (E1) par lesdits deux circuits intégrateurs.

2. Dispositif selon la revendication 1, caractérisé par le fait que ledit circuit de compensation comprend une combinaison de circuits analogiques destinée à élaborer la différence quadratique entre les signaux des deux entrées.

3. Dispositif selon la revendication 2, caractérisé par le fait que ladite combinaison du circuit de compensation comporte deux circuits élaborant respectivement la somme et la différence des signaux reçus à leurs deux entrées, qui sont connectés directement auxdites deux entrées (E1, E2) du circuit de compensation, puis un circuit multiplicateur dont les deux entrées proviennent des deux circuits précédents, et enfin un circuit multiplicateur bouclé de manière à extraire la racine carrée du signal sortant du multiplicateur précédent, la sortie de ce dernier circuit étant dirigée vers l'amplificateur à gain commandé.

4. Dispositif selon l'une quelconque des revendications précédentes, caractérisé par le fait que lesdits circuits intégrateurs (R1C1 et R2C2) ont une constante de temps voisine de 6 secondes.

5. Dispositif selon une quelconque des revendications précé-

0026929

dentes, caractérisé par le fait que chacun desdits premier et second circuits connectés auxdites première et seconde entrées comportent en amont de leur dispositif redresseur correspondant (D1 ou D2) un filtre correcteur (F'C, FC) dont la courbe de réponse est peu différente mais présente une différence appropriée pour linéariser en fréquence la courbe de réponse de la chaîne transductrice.

6. Dispositif selon la revendication 5, caractérisé par le fait que la courbe de réponse desdits filtres (F'C et FC) est une courbe en cloche qui tombe à 12dB par octave pour des fréquences extrêmes voisines de 500 et 4000 Hz.

1/1

0026929

**Office européen
des brevets**

**RAPPORT DE RECHERCHE EUROPEENNE**

0026929

Numéro de la demande

EP 80 10 6008

| Catégorie | Citation du document avec indication, en cas de besoin, des parties pertinentes | Revendication concernée |
|---|---|---|
| | DE - A - 2 501 530 (DEUTSCHE BUNDES-BAHN) <br> * Figures 3 et 2; revendications 1-5; page 9 à partir de la ligne 4 * <br><br> -- | 1 |
| | DE - A - 2 604 936 (BECKSTEIN) <br> * Page 4, ligne 23 à page 5, ligne 7 * <br><br> -- | 1 |
| | DE - A - 2 525 175 (BLAUPUNKT-WERKE) <br> * Figure unique; pages 3 et 4 * <br><br> ---- | 1 |

## DOCUMENTS CONSIDERES COMME PERTINENTS

**CLASSEMENT DE LA DEMANDE (Int. Cl. 3)**

H 03 G 3/32

**DOMAINES TECHNIQUES RECHERCHES (Int. Cl. 3)**

H 03 G

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons
&: membre de la même famille, document correspondant

Le présent rapport de recherche a été établi pour toutes les revendications

| Lieu de la recherche | Date d'achèvement de la recherche | Examinateur |
|---|---|---|
| La Haye | 07-01-1981 | GYSEN |

OEB Form 1503.1   06.78